# EUROPEAN PATENT APPLICATION

(11) **EP 2 211 394 A2**
(43) Date of publication of application: **28.07.2010**
(21) Application number: 09252677.1
(22) Date of filing: 25.11.2009
(51) Int. Cl.: H01L 33/48

(54) **Light emitting diode package structure**

(30) Priority: 23.01.2009 TW 98102929
(71) Applicant: Everlight Electronics Co., Ltd., Tucheng T'ai pei (TW)
(72) Inventor: Chou, Yen-Fu, Tucheng, Taipei (TW)
(74) Representative: Oxley, Robin John George

(57) **Abstract**

An LED package structure (100) includes a carrier (110), a housing (120), an LED chip (130), an encapsulant (140) and a surface treatment layer (150). The housing is disposed on the carrier and has an upper surface (122), wherein the housing and the carrier together form a chip-containing cavity (C'). The LED chip is disposed on the carrier and located in the chip-containing cavity. The encapsulant is disposed in the chip-containing cavity and encapsulates the LED chip. The surface treatment layer is disposed on the upper surface of the housing to prevent the encapsulant from adhering to the upper surface of the housing.

## Description

### BACKGROUND OF THE INVENTION

### Field of the Invention

The present invention generally relates to a semiconductor package structure, and more particularly, to a light emitting diode (LED) package structure.

### Description of Related Art

LEDs have many advantages, such as long lifetime, small volume, high shock absorption, low heat and power saving, so that LEDs have been used in the fields of indicators or light sources in home appliances and various equipments. In recent years, LEDs have had developments towards high coroma and high luminance and have been expanded to mega-size display board, traffic light and the related fields already. It can be expected, in future, LEDs would even become a major kind of illumination light source featuring power saving as an environmentally friendly product.

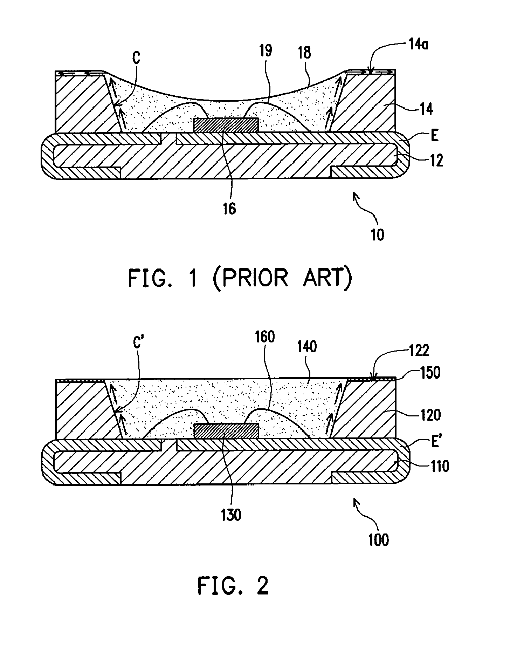

Fig. 1 is a cross-sectional diagram of a conventional LED package structure. Referring to Fig. 1, an LED package structure 10 includes a carrier 12, a housing 14, an LED chip 16 and an encapsulant 18. The LED chip 16 is disposed on the carrier 12 and located in a chip-containing cavity C formed by the carrier 12 and the housing 14, wherein the LED chip 16 is electrically connected to the carrier 12 by two bonding wires 19. The encapsulant 18 fills in the chip-containing cavity C to encapsulate the LED chip 16 and the bonding wires 19. A part of the carrier 12 exposed outside the encapsulant 18 serves as an external electrode E, which becomes a medium to electrically connect the LED package structure 10 to the outside.

In the prior art, when the encapsulant 18 fills in the chip-containing cavity C, since the adhesion between the encapsulant 18 and the chip-containing cavity C is greater than the cohesion of the encapsulant 18 itself, the part of the encapsulant 18 located surrounding the chip-containing cavity C would be a little higher than the center part of the encapsulant 18, which is termed as capillary phenomenon. In more details, due to the capillary phenomenon, the encapsulant 18 located in the chip-containing cavity C becomes dented, which results in unstable light-emitting uniformity of the LED package structure 10. In addition, the part of the encapsulant 18 located surrounding the chip-containing cavity C may partially overflow onto an upper surface 14a of the housing 14 to cause the LED package structure 10 to get flash contamination.

### SUMMARY OF THE INVENTION

Accordingly, the present invention is directed to a LED package structure able to eliminate the flash contamination on the surface of the housing thereof.

The present invention provides an LED package structure, which includes a carrier, a housing, an LED chip, an encapsulant and a surface treatment layer. The housing is disposed on the carrier and has an upper surface, wherein the housing and the carrier together form a chip-containing cavity. The LED chip is disposed on the carrier and located in the chip-containing cavity. The encapsulant is disposed in the chip-containing cavity and encapsulates the LED chip. The surface treatment layer is disposed on the upper surface of the housing to prevent the encapsulant from adhering to the upper surface of the housing.

In an embodiment of the present invention, the above-mentioned surface treatment layer is an ink layer.

In an embodiment of the present invention, the material of the above-mentioned ink layer includes a combination of 4-hydroxy-4-methylpentan-2-one, cyclohexanone, xylene, butylglycol acetate, solvent naphtha, mesitylene, resin and black carbon.

In an embodiment of the present invention, the material of the above-mentioned ink layer includes a combination of 4-hydroxy-4-methylpentan-2-one, cyclohexanone, xylene, butylglycol acetate, solvent naphtha, mesitylene, resin and aromatic hydrocarbons.

In an embodiment of the present invention, the above-mentioned surface treatment layer adheres onto the upper surface of the housing by using roller printing.

In an embodiment of the present invention, the surface of the above-mentioned encapsulant is substantially level with the surface of the surface treatment layer.

In an embodiment of the present invention, the above-mentioned encapsulant is protruded from the housing and the surface of the encapsulant is higher than the surface of the surface treatment layer.

In an embodiment of the present invention, the above-mentioned LED package structure further includes at least a bonding wire, wherein the LED chip is electrically connected to the carrier by the bonding wire.

In an embodiment of the present invention, the above-mentioned carrier includes a circuit board or a lead frame.

In an embodiment of the present invention, the above-mentioned the carrier and the housing are integrated formed.

Based on the described above, the LED package structure of the present invention has a surface treatment layer; when an encapsulant fills in the chip-containing cavity, since the joint force between the surface treatment layer and the encapsulant is less than the joint force between the encapsulant and the housing, the encapsulant is unlikely to adhere onto the surface treatment layer and accordingly the encapsulant would not overflow onto the upper surface of the housing. In this way, the LED package structure of the present invention can avoid getting flash contamination.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

Fig. 1 is a cross-sectional diagram of a conventional LED package structure.

Fig. 2 is a cross-sectional diagram of an LED package structure according to an embodiment of the present invention.

Fig. 3 is a cross-sectional diagram of an LED package structure according to another embodiment of the present invention.

### DESCRIPTION OF THE EMBODIMENTS

Reference will now be made in detail to the present preferred embodiments of the invention, examples of which are illustrated in the accompanying drawings. Wherever possible, the same reference numbers are used in the drawings and the description to refer to the same or like parts.

Fig. 2 is a cross-sectional diagram of an LED package structure according to an embodiment of the present invention. Referring to Fig. 2, in the embodiment, an LED package structure 100 includes a carrier 110, a housing 120, an LED chip 130, an encapsulant 140 and a surface treatment layer 150. In particular, the LED package structure 100 in the embodiment is an LED package structure 100 in surface mount device mode (SMD mode).

In more details, the housing 120 is disposed on the carrier 110 and has an upper surface 122, wherein the housing 120 and the carrier 110 together form a chip-containing cavity C' and the carrier 110 and the housing 120 is integratedly formed. In the embodiment, the carrier 110 is, for example, a circuit board, or a lead frame in other embodiments. In short, the carrier 110 of Fig. 2 is an example only, which the present invention is not limited to.

The LED chip 130 is disposed on the carrier 110 and located in the chip-containing cavity C' for emitting light. In the embodiment, the LED package structure 100 further includes at least a bonding wire 160 (in Fig. 2, for example, two bonding wires 160 are shown), wherein the LED chip 130 is electrically connected to the carrier 110 by the bonding wires 160.

The encapsulant 140 is disposed in the chip-containing cavity C' to encapsulate the LED chip 130 and the bonding wires 160, the encapsulant 140 protects the LED chip 130 and the bonding wires 160 from being affected by the external temperature, moisture and noise. The part of the carrier 110 exposed to the encapsulant 140 is an external electrode E' and serves as a medium to electrically connected the LED package structure 100 to the outside.

The surface treatment layer 150 is disposed on the upper surface 122 of the housing 120, and the surface treatment layer 150 is for preventing the encapsulant 140 from adhering onto the upper surface 122 of the housing 120. In the embodiment, the surface of the encapsulant 140 is substantially level with the surface of the surface treatment layer 150. The surface treatment layer 150 adheres onto the upper surface 122 of the housing 120 by using roller printing.

It should be noted that in the embodiment, the surface treatment layer 150 is, for example, an ink layer, and the ink layer is made of a combination of 4-hydroxy-4-methylpentan-2-one with content of 10-22%, cyclohexanone with content of 1-10%, xylene with content of 5-15%, butylglycol acetate with content of 1-15%, solvent naphtha with content less than 5%, mesitylene with content less than 5%, resin with content of 15-20% and black carbon with content of 3-5%. In other embodiments however, the above-mentioned black carbon with content of 3-5% can be replaced by aromatic hydrocarbons with content of 1-3% according to the required color of the ink layer, so that the color of the ink layer is changed from the original black of the black carbon into transparent one.

It should be noted that when the chip-containing cavity C' is filled with the encapsulant 140 in an appropriate volume, although the adhesion between the encapsulant 140 and the chip-containing cavity C' is greater than the cohesion of the encapsulant 140 itself and the part of the encapsulant 140 located surrounding the chip-containing cavity C' is a little higher than the center part of the encapsulant 140 caused by the so-called capillary phenomenon, however, since the joint force between the surface treatment layer 150 disposed on the upper surface 122 of the housing 120 and the encapsulant 140 is less than the joint force between the encapsulant 140 and the housing 120, so that the encapsulant 140 unlikely adheres onto the surface treatment layer 150. That is to say, the encapsulant 140 unlikely overflows onto the upper surface 122 of the housing 120; on the contrary, the surface of the encapsulant 140 is substantially level with the surface of the surface treatment layer 150 or the surface of the encapsulant 140 is lower than the surface of the surface treatment layer 150.

In short, the LED package structure 100 of the embodiment has a surface treatment layer 150. When the chip-containing cavity C' is filled with the encapsulant 140, since the joint force between the surface treatment layer 150 and the encapsulant 140 is less than the joint force between the encapsulant 140 and the housing 120, the encapsulant 140 unlikely adheres onto the surface treatment layer 150. That is to say, the encapsulant 140 unlikely overflows onto the upper surface 122 of the housing 120. In this way, the LED package structure 100 of the embodiment can avoid getting flash contamination.

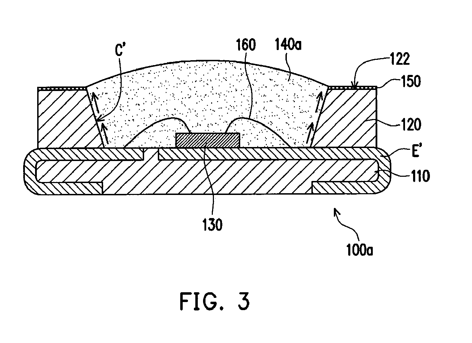

Fig. 3 is a cross-sectional diagram of an LED package structure according to another embodiment of the present invention. Referring to Figs. 3 and 2, in the embodiment, the LED package structure 100a of Fig. 3 is similar to the LED package structure 100 of Fig. 2 except that the encapsulant 140a of Fig. 3 is protruded from the housing 120 and the surface of the encapsulant 140 is higher than the surface of the surface treatment layer 150.

In more details, in the embodiment, when the encapsulant 140a in excessive volume fills the chip-containing cavity C', the adhesion between the encapsulant 140a and the chip-containing cavity C' is greater than the cohesion of the encapsulant 140a itself to make the part of the encapsulant 140a located surrounding the chip-containing cavity C' a little higher than the center part of the encapsulant 140a. However, since the joint force between the surface treatment layer 150 disposed on the upper surface 122 of the housing 120 and the encapsulant 140a is less than the joint force between the encapsulant 140a and the package housing 120, and the surface tension between the surface treatment layer 150 and the encapsulant 140a is much greater than the cohesion of the encapsulant 140a itself, so that the excessive encapsulant 140a would be protruded from the housing 120 and the encapsulant 140a would not adhere onto the surface treatment layer 150, which means the encapsulant 140a would not overflow onto the upper surface 122 of the housing 120.

It should be noted that in the embodiment, since the encapsulant 140a would not overflow onto the upper surface 122 of the housing 120, the encapsulant 140a located in the chip-containing cavity C' would not become dented. In comparison with the prior art, the light-emitting uniformity of the LED package structure 100a of the embodiment is more stable. In particular, the part of the encapsulant 140a protruded from the housing 120 can be considered as a convex lens. As a result, when the light emitted from the LED chip 130 passes outside through the encapsulant 140a, the LED package structure 100a can have better light-emitting uniformity.

In summary, the LED package structure of the present invention has a surface treatment layer, so that when the encapsulant fills the chip-containing cavity, the adhesion between the encapsulant and the chip-containing cavity is greater than the cohesion of the encapsulant itself to make the part of the encapsulant located surrounding the chip-containing cavity a little higher than the center part of the encapsulant. However, since the joint force between the surface treatment layer and the encapsulant is less than the joint force between the encapsulant and the housing, the encapsulant unlikely adheres onto the surface treatment layer, which means the encapsulant would not overflow onto the upper surface of the housing. In this way, the LED package structure of the present invention can avoid getting flash contamination.

In addition, since the encapsulant does not overflow onto the upper surface of the housing and the encapsulant can be substantially level with the surface of the surface treatment layer or protruded from the housing by controlling the volume of the encapsulant to fill the chip-containing cavity, so that when the light emitted from the LED chip goes outside through the encapsulant, an unstable problem of the light-emitting uniformity caused by the capillary phenomenon in the prior art can be prevented. In other words, the LED package structure of the present invention has better color uniformity of light and thereby the invented LED package structure has better light-emitting uniformity.

It will be apparent to those skilled in the art that various modifications and variations can be made to the structure of the present invention without departing from the scope or spirit of the invention. In view of the foregoing, it is intended that the present invention covers modifications and variations of this invention provided they fall within the scope of the following claims and their equivalents.

## Claims

1. A light emitting diode package structure (100, 100a), comprising:
a carrier (110);
a housing (120), disposed on the carrier and having an upper surface (122), wherein the housing and the carrier together form a chip-containing cavity (C');
a light emitting diode chip (130), disposed on the carrier and located in the chip-containing cavity;
an encapsulant (140, 140a), filled in the chip-containing cavity and encapsulating the light emitting diode chip; and
a surface treatment layer (150), disposed on the upper surface of the housing, wherein the surface treatment layer is for preventing the encapsulant from adhering to the upper surface of the housing.

2. A light emitting diode package structure as claimed in claim 1, wherein the surface treatment layer is an ink layer.

3. A light emitting diode package structure as claimed in claim 2, wherein the material of the ink layer is selected from the groups of 4-hydroxy-4-methylpentan-2-one, cyclohexanone, xylene, butylglycol acetate, solvent naphtha, mesitylene, resin, black carbon and the combination thereof.

4. A light emitting diode package structure as claimed in claim 2, wherein the material of the ink layer is selected from the groups of 4-hydroxy-4-methylpentan-2-one, cyclohexanone, xylene, butylglycol acetate, solvent naphtha, mesitylene, resin, aromatic hydrocarbons and the combination thereof.

5. A light emitting diode package structure as claimed in any one of claims 1 to 4, wherein the surface treatment layer adheres onto the upper surface of the housing by using roller printing.

6. A light emitting diode package structure as claimed in any preceding claim, wherein the surface of the encapsulant is substantially level with the surface of the surface treatment layer.

7. A light emitting diode package structure as claimed in any one of claims 1 to 5, wherein the encapsulant is protruded from the housing and the surface of the encapsulant is higher than the surface of the surface treatment layer.

8. A light emitting diode package structure as claimed in any preceding claim, further comprising at least a bonding wire (160), wherein the light emitting diode chip is electrically connected to the carrier by the bonding wire.

9. A light emitting diode package structure as claimed in any preceding claim, wherein the carrier comprises a circuit board or a lead frame.

10. A light emitting diode package structure as claimed in any preceding claim, wherein the carrier and the housing are integratedly formed.
